**Europäisches Patentamt**

**European Patent Office**

**Office européen des brevets**

(11) Numéro de publication : **0 452 557 B1**

(12)
# FASCICULE DE BREVET EUROPEEN

(45) Date de publication du fascicule du brevet :
28.09.94 Bulletin 94/39

(51) Int. Cl.⁵ : **G01R 19/32**

(21) Numéro de dépôt : **90124567.0**

(22) Date de dépôt : **18.12.90**

(54) **Circuit de mesure du niveau d'un signal comprenant des moyens de correction de décalage.**

(30) Priorité : **22.12.89 FR 8917107**

(43) Date de publication de la demande :
**23.10.91 Bulletin 91/43**

(45) Mention de la délivrance du brevet :
**28.09.94 Bulletin 94/39**

(84) Etats contractants désignés :
**AT BE CH DE ES FR GB IT LI NL SE**

(56) Documents cités :
**EP-A- 0 332 547**

(73) Titulaire : **ALCATEL CIT**
**12 Rue de la Baume**
**F-75008 Paris (FR)**

(72) Inventeur : **Nguyen, Quang-Tan**
**22bis, rue de Lozère**
**F-91400 Orsay (FR)**

(74) Mandataire : **Weinmiller, Jürgen et al**
**Lennéstrasse 9**
**Postfach 24**
**D-82336 Feldafing (DE)**

## Description

La présente invention concerne un circuit qui effectue la mesure du niveau d'un signal électrique, cette mesure étant éventuellement faite par rapport à une tension de référence. Elle s'applique avantageusement dans le cadre des amplificateurs à commande automatique de gain.

Elle intéresse principalement le cas où ce signal est alternatif bien qu'elle s'applique également s'il est continu.

La mesure du niveau d'un signal est couramment réalisée au moyen d'une chaîne de mesure comprenant un amplificateur d'entrée suivi d'un module de détection lui-même suivi d'un intégrateur. L'amplificateur qui comprend des moyens de polarisation produit un signal de sortie composé d'une part du signal d'entrée amplifié et d'autre part d'une composante continue résultant de la polarisation et de différentes tensions de seuil ayant pour origine les caractéristiques de conduction des composants utilisés. Le module de détection qui reçoit ce signal de sortie redresse en simple ou en double alternance la fraction de ce signal qui est proportionnelle au signal d'entrée, conserve ladite composante continue, et lui ajoute un décalage de tension dû à ses propres moyens de polarisation et tensions de seuil. L'intégrateur disposé à la sortie du module de détection produit donc un signal d'intégration qui est la somme d'une tension proportionnelle au niveau du signal d'entrée et d'une tension de décalage issue des diverses polarisations et tensions de seuil.

De manière à éliminer la tension de décalage on emploie généralement un amplificateur de mesure différentiel recevant le signal d'intégration et un signal de correction et produisant un signal de mesure qui est la différence des deux signaux précédents. Le signal de correction doit être égal à la tension de décalage. Il est habituellement élaboré au moyen d'un potentiomètre connecté aux bornes de l'alimentation du circuit. Ce potentiomètre est alors réglé pour une tension d'alimentation donnée et une température donnée de manière à ce que le signal de correction soit égal à la tension de décalage, en l'absence de signal d'entrée par exemple. Si la tension d'alimentation et/ou la température du circuit varie(nt) le signal de correction et la tension de décalage vont varier de manière différente, leur différence ne restant donc pas nulle. En effet les éléments de la chaîne de mesure comprennent des composants semi-conducteurs qui sont non linaires et qui présentent un coefficient de température bien différent de celui du potentiomètre. Il en résultera une erreur qui est inacceptable dans certaines applications.

La présente invention a ainsi pour objet un circuit de mesure du niveau d'un signal dans lequel la tension de décalage et le signal de correction ont la même valeur quelles que soient les conditions de fonctionnement.

Selon l'invention, le circuit de mesure du niveau d'un signal électrique d'entrée comprend un amplificateur d'entrée polarisé à partir d'une tension de polarisation recevant ce signal d'entrée et produisant un signal de sortie, suivi d'un module de détection lui-même suivi d'un intégrateur délivrant un signal d'intégration, ces trois éléments constituant une chaîne de mesure, le signal d'intégration étant la somme d'un signal de niveau proportionnel au niveau du signal d'entrée et d'un signal de décalage. Ce circuit de mesure comprend de plus un générateur produisant une tension de référence, un module de compensation recevant cette tension de référence et produisant un signal de compensation, un amplificateur de mesure différentiel recevant les signaux d'intégration et de compensation et produisant un signal de mesure, et se caractérise en ce que la tension de polarisation est la tension de référence et en ce que le module de compensation comprend des étages correspondant au éléments de la chaîne de mesure pour acheminer la tension de référence dans des conditions homothétiques de celles de la chaîne de mesure pour produire notamment un signal de correction ayant même valeur que le signal de décalage, ce signal de correction étant inclus dans le signal de compensation.

De plus, dans le circuit de mesure du niveau d'un signal électrique, le module de compensation produit un signal de compensation comprenant, outre le signal de correction, un signal d'évaluation proportionnel à la tension de référence générant au travers dudit amplificateur de mesure un signal de comparaison également proportionnel à la tension de référence, le signal de mesure étant proportionnel à la différence entre le signal de comparaison et le niveau du signal d'entrée.

Dans un mode de réalisation, le circuit de mesure du niveau d'un signal électrique se caractérise en ce que le signal d'entrée est un signal différentiel, l'amplificateur d'entrée comprend un premier transistor et un deuxième transistor identiques recevant chacun sur leurs bases une voie dudit signal d'entrée, le collecteur du premier transistor étant raccordé à une tension d'alimentation par l'intermédiaire d'une première résistance, le collecteur du deuxième transistor étant raccordé à cette tension d'alimentation par l'intermédiaire d'une deuxième résistance ayant même valeur que la première résistance, les émetteurs de ces transistors étant reliés au collecteur d'un troisième transistor dont l'émetteur est relié à la masse par une troisième résistance et dont la base reçoit la tension de référence par l'intermédiaire d'une première diode homothétique de la jonction base-émetteur du troisième transistor, cette diode étant polarisée par une première résistance de diode reliée à la tension d'alimentation.

De plus, dans le circuit de mesure du niveau d'un signal électrique, le module de détection comprend un quatrième transistor dont la base est raccordée au collecteur du deuxième transistor et dont le collecteur est relié à la tension d'alimentation, un cinquième transistor dont la base est raccordée au collecteur du premier transistor et dont le collecteur est relié à ladite tension d'alimentation, les émetteurs des quatrième et cinquième transistors ayant un point commun qui est relié à la masse par une résistance commune.

En outre, dans le circuit de mesure du niveau d'un signal électrique, l'intégrateur est formé d'une cellule R-C, la résistance d'intégration de cette cellule reliant ce point commun à la première entrée de l'amplificateur de mesure, le condensateur d'intégration de cette cellule étant relié d'une part à cette première entrée et d'autre part soit à la masse, soit à la sortie de cet amplificateur de mesure.

Par ailleurs, dans le circuit de mesure du niveau d'un signal électrique, le module de compensation comprend un premier étage correspondant à l'amplificateur d'entrée constitué d'un sixième transistor homothétique du troisième transistor, dont l'émetteur est relié à la masse par une sixième résistance, dont le collecteur est relié à la tension d'alimentation par une septième résistance et dont la base reçoit ladite tension de référence par l'intermédiaire d'une deuxième diode homothétique de la première diode et de la jonction base-émetteur de ce sixième transistor, cette deuxième diode étant polarisée par une deuxième résistance de diode reliée à la tension d'alimentation; en outre il comprend un deuxième étage correspondant au module de détection constitué d'un septième transistor, homothétique du quatrième transistor, monté en collecteur commun, dont la base est reliée au collecteur du sixième transistor et dont l'émetteur est relié d'une part à la masse par une résistance et d'autre part à la deuxième entrée de l'amplificateur de mesure par une résistance de compensation.

Avantageusement, dans le circuit de mesure du niveau d'un signal électrique, l'ensemble des première et deuxième diodes est formé par une seule diode homothétique aux jonctions base-émetteur des troisième et sixième transistors et l'ensemble des résistances de diode est formé par une seule résistance.

De plus, dans le circuit de mesure du niveau d'un signal électrique, tous les éléments de la chaîne de mesure et du module de compensation à l'exception du condensateur d'intégration de l'intégrateur sont intégrés dans un circuit monolithique.

Par ailleurs, dans le circuit de mesure du niveau d'un signal électrique, le condensateur d'intégration est également intégré dans ce circuit monolithique.

Avantageusement, dans le circuit de mesure du niveau d'un signal électrique, le générateur est un module dont la tension de sortie est référencée à la bande d'énergie interdite (band-gap) d'un semi-conducteur.

Ainsi, dans le circuit de mesure du niveau d'un signal électrique, le générateur est également intégré dans ce circuit monolithique.

De même, dans le circuit de mesure du niveau d'un signal électrique, l'amplificateur de mesure est également intégré dans ce circuit monolithique.

Le circuit de mesure du niveau d'un signal électrique selon l'invention trouvera application dans à un circuit à commande automatique de gain, ce circuit comprenant un amplificateur à commande automatique de gain produisant le signal d'entrée à partir d'un signal de réception et recevant comme signal de commande le signal de mesure.

En outre, dans cette application du circuit de mesure du niveau d'un signal électrique, l'amplificateur d'entrée est l'étage de sortie de l'amplificateur à commande automatique de gain.

Le circuit de mesure du niveau d'un signal électrique selon l'invention trouvera une autre application à la démodulation d'un signal modulé en amplitude, le signal de correction constituant le signal de compensation.

Les différents objets et caractéristiques de l'invention seront maintenant exposés avec plus de détails dans le cadre d'un exemple de réalisation donné à titre non limitatif en se référant aux figures annexées qui représentent :

- la figure 1, un diagramme par blocs du circuit de mesure du niveau d'un signal électrique selon l'invention,
- la figure 2, un schéma électrique d'une réalisation particulière de ce circuit de mesure,
- la figure 3, un diagramme par blocs d'une application de ce circuit de mesure aux circuits à commande automatique de gain.

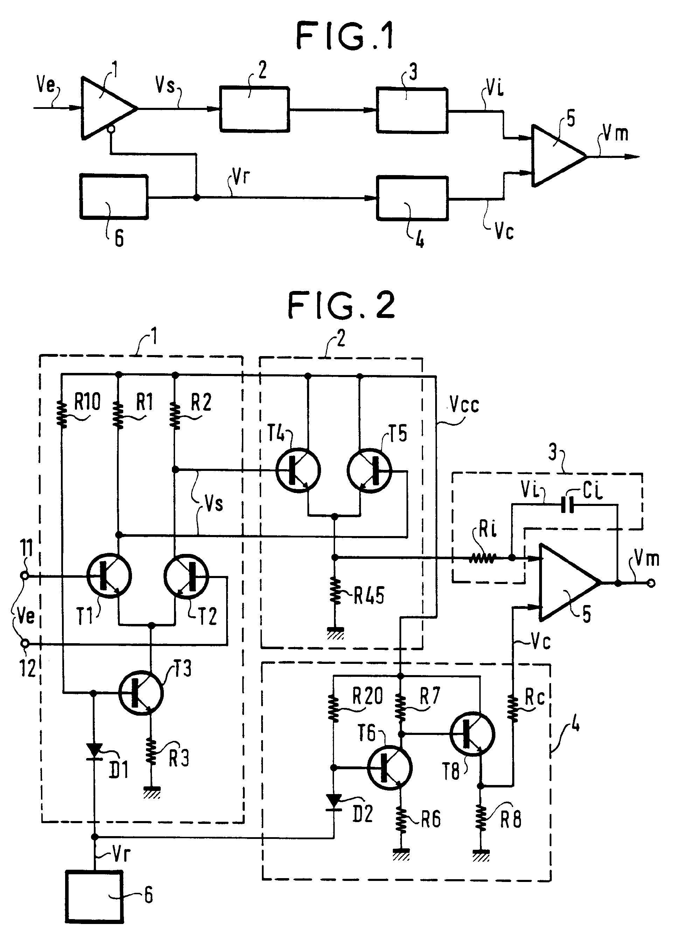

Le circuit de mesure du niveau d'un signal dont un diagramme par blocs est présenté à la figure 1, comprend une chaîne de mesure constituée d'un amplificateur 1 recevant un signal d'entrée $V_e$ et produisant un signal de sortie $V_S$, un module de détection 2 recevant ce signal de sortie, et à la suite de ce module, un intégrateur 3 délivrant un signal d'intégration $V_i$. Le signal de sortie $V_S$ est composé pour partie d'un signal alternatif proportionnel au signal d'entrée $V_e$ et pour partie d'une composante continue due aux polarisations et aux différentes tensions de seuil des éléments semi-conducteurs tels que des diodes ou des transistors qui sont présents dans l'amplificateur d'entrée. Le module de détection produit un signal composé pour partie d'un signal redressé correspondant au signal alternatif produit par l'amplificateur d'entrée et pour partie d'une tension de décalage issue des diverses polarisations et tensions de seuil de l'amplificateur d'entrée et de ce

3

module. L'intégrateur 3, ainsi dénommé eu égard à sa fonction de moyennage, est un filtre passe-bas et fournit donc un signal d'intégration qui est la somme de cette tension de décalage et d'un signal de niveau proportionnel au niveau du signal d'entrée.

Le circuit de mesure comprend également un module de compensation 4 recevant une tension de référence $V_r$ et produisant un signal de compensation $V_c$.

Il comprend de plus un amplificateur de mesure différentiel 5 qui reçoit le signal d'intégration et le signal de compensation et qui produit un signal de mesure $V_m$ proportionnel à la différence de ces deux signaux.

Il comprend enfin un générateur 6 qui produit la tension de référence $V_r$ et la fournit conjointement à l'amplificateur d'entrée 1 et au module de compensation. Cette tension de référence est utilisée pour imposer les conditions de fonctionnement, notamment les valeurs de polarisation, des divers éléments de la chaîne de mesure et du module de compensation.

Le module de compensation 4 comprend des étages homothétiques des divers étages de la chaîne de mesure. Par homothétique, il faut entendre travaillant dans les mêmes conditions, ainsi, deux transistors ou diodes sont homothétiques s'ils sont à la même température et s'ils sont traversés par la même densité de courant, présentant donc les mêmes tensions de seuil et les mêmes coefficients d'amplification. Ce module de compensation peut ainsi délivrer un signal qui compense exactement la tension de décalage de la chaîne de mesure.

Un exemple de réalisation sera maintenant exposé dans le détail en se référant à la figure 2 qui est un schéma électrique du circuit de mesure. Cet exemple est donné pour préciser les différentes relations qui unissent le module de compensation et la chaîne de mesure. L'invention ne se limite pas à ce circuit particulier.

Le circuit de mesure est alimenté par une source d'alimentation délivrant une tension continue positive $V_{cc}$ référencée à la masse.

Le générateur 6 qui produit la tension de référence est réalisé par exemple au moyen d'une diode Zener à faible coefficient de température ou d'un circuit dont la tension de sortie est référencée à la bande d'énergie interdite (band-gap) d'un semi-conducteur tel que du silicium. Un circuit de ce type est décrit notamment dans l'ouvrage "Analysis and design of analog integrated circuits" de Paul GRAY et Robert MEYER, édité par John WILEY and sons en 1984 aux pages 289 à 296. La tension de sortie $V_r$ peut être considérée comme constante.

L'amplificateur d'entrée 1 est ici un amplificateur différentiel de gain en tension $K_1$ qui a deux bornes d'accès 11, 12. Le signal d'entrée $V_e$ est la différence de potentiel entre ces deux bornes. Cet amplificateur comprend donc une paire de transistors $T_1$, $T_2$, dont les bases sont respectivement reliées aux bornes 11, 12 et dont les collecteurs sont reliés à l'alimentation $V_{cc}$ par deux résistances respectivement $R_1$, $R_2$ de même valeur. Les émetteurs des transistors $T_1$, $T_2$ sont reliés au collecteur d'un transistor $T_3$ qui fonctionne à courant constant car sa base est reliée d'une part à l'alimentation $V_{cc}$ par l'intermédiaire d'une résistance $R_{10}$ et d'autre part au générateur 6 par l'intermédiaire d'une diode $D_1$. L'émetteur du transistor $T_3$ est relié à la masse par une résistance $R_3$. La diode $D_1$ est choisie pour être homothétique à la jonction base-émetteur du transistor $T_3$, ces deux éléments présentant donc à leurs bornes une différence de potentiel équivalente quelles que soient les conditions d'utilisation. La tension d'émetteur du transistor $T_3$ qui est une tension de polarisation est donc égale à la tension de référence $V_r$.

- Le courant d'émetteur de $T_3$ vaut $V_r/R_3$.
- Le courant de collecteur de $T_3$ vaut $(V_r/R_3).(\beta_3/(\beta_3 +1))$ où $\beta_3$ est le coefficient d'amplification en courant de $T_3$.
- Les tensions des collecteurs des transitors $T_1$ et $T_2$ sont égales car les résistances $R_1$ et $R_2$ sont égales et ces transistors sont identiques ; le courant de collecteur de ces transistors en l'absence de signal d'entrée $V_e$ vaut la moitié du courant de collecteur du transistor $T_3$ si on néglige les courants de base de ces mêmes transistors. Ces tensions de collecteur valent donc
$$V_{cc} - (R_1/2) . (V_r/R_3) . (\beta_3/(\beta_3 + 1))$$
- En présence d'un signal d'entrée $V_e$ non nul les collecteurs des transistors $T_1$ et $T_2$ sont l'un à une tension
$$V_{cc} - (R_1/2R_3).(\beta_3/(\beta_3 + 1)). V_r - K_1 V_e$$
l'autre à une tension
$$V_{cc} - (R_1/2R_3) . (\beta_3/(\beta_3 + 1)). V_r + K_1 V_e.$$

Le module de détection 2 comprend deux transistors identiques $T_4$, $T_5$ dont les collecteurs sont reliés à $V_{cc}$ et dont les émetteurs ont un point commun qui est relié à la masse par l'intermédiaire d'une résistance $R_{45}$. La base du transistor $T_4$ est reliée au collecteur du transistor $T_2$, tandis que celle du transistor $T_5$ est reliée au collecteur du transistor $T_1$. En l'absence de signal d'entrée, ce point commun est donc à la tension des collecteurs des transistors $T_1$ et $T_2$ diminuée de la tension base émetteur des transistors $T_4$ ou $T_5$ qui sont identiques, soit $V_{be4}$, c'est-à-dire à une tension égale à
$$V_{cc} - (R_1/2R_3) . (\beta_3/(\beta_3 + 1)) . V_r - V_{be4} . \text{Si } |V_e|$$
représente la valeur absolue de $V_e$, la tension du point commun est donc

$$V_{cc} - (R_1/2R_3) . (\beta_3/(\beta_3 + 1)) . V_r - V_{be4} + K_1 |V_e|$$

à tout instant puisqu'il s'agit d'un redresseur double alternance.

L'intégrateur 3 est une cellule du type R.C connue. Il comprend donc une résistance $R_i$ connectée au point commun des émetteurs des transistors $T_4$ et $T_5$ et à l'entrée négative de l'amplificateur différentiel 5. Le condensateur $C_i$ de cette cellule est raccordé lui aussi à cette entrée de l'amplificateur 5 et, par son autre borne, à la sortie de ce même amplificateur. Bien qu'il soit possible de le raccorder à la masse, le fait de le raccorder de cette manière équivaut à multiplier sa capacité par le gain de l'amplificateur. Si $I_-$ est le courant d'entrée de l'amplificateur 5 sur son entrée négative et $V_e *$ le niveau du signal d'entrée, le signal d'intégration $V_i$ appliqué sur cette entrée vaut :

$$V_i = V_{cc} - (R_1/2R_3) . (\beta_3/(\beta_3 + 1)) . V_r - V_{be4} + K_1 V_e * - R_i I_-$$

$V_i$ peut s'écrire sous une autre forme en introduisant la tension de décalage $V_d$ :

$$V_d = V_{cc} - (R_1/2R_3) . (\beta_3/(\beta_3 + 1)) . V_r - V_{be4} - R_i I_- \quad V_i = K_1 V_e * + V_d$$

Le module de compensation 4 comprend deux étages prévus pour compenser les décalages dus respectivement à l'amplificateur d'entrée 1 et au module de détection 2. Le premier étage comprend un transistor $T_6$ qui fonctionne à courant constant comme le transistor $T_3$, car sa base est reliée d'une part à l'alimentation $V_{cc}$ par l'intermédiaire d'une résistance $R_{20}$ et d'autre part au générateur 6 par l'intermédiaire d'une diode $D_2$. L'émetteur du transistor $T_6$ est relié à la masse par une résistance $R_6$ et son collecteur à $V_{cc}$ par une résistance $R_7$. La diode $D_2$ étant homothétique à la jonction base-émetteur du transistor $T_6$, ces deux éléments présentent à leurs bornes une différence de potentiel identique quelles que soient les conditions d'utilisation. La tension d'émetteur du transistor $T_6$ est donc égale à la tension de référence $V_r$.

- le courant d'émetteur de $T_6$ vaut $V_r/R_6$
- la tension de collecteur du transistor $T_6$ vaut donc

$$V_{cc} - (R_7/R_6) . (\beta_6/(\beta_6 + 1)) . V_r$$

où $\beta_6$ est le coefficient d'amplification en courant du transistor $T_6$.

Le deuxième étage qui correspond au module de détection 2 comprend un transistor $T_8$ monté en collecteur commun dont l'émetteur est raccordé à la masse par une résistance $R_6$ et à l'entrée positive de l'amplificateur de mesure 5 par une résistance $R_c$. La base du transistor $T_8$ est raccordée au collecteur du transistor $T_6$, donc la tension d'émetteur du transistor $T_8$ vaut

$$V_{cc} - (R_7/R_6) . (\beta_6/(\beta_6 + 1)) . V_r - V_{be8}$$

où $V_{be8}$ est la tension base-émetteur du transistor $T_8$. Si $I_+$ est le courant d'entrée de l'amplificateur 5 sur son entrée positive, le signal de compensation $V_c$ appliqué sur cette entrée vaut :

$$V_c = V_{cc} - (R_7/R_6) . (\beta_6/(\beta_6 + 1)) . V_r - V_{be8} - R_c I_+.$$

L'amplificateur de mesure 5 ayant un gain G produit donc un signal de mesure $V_m = G . (V_c - V_i)$

$$V_m = G \left[ V_{cc} - (R_7/R_6) . (\beta_6/(\beta_6 + 1)) . V_r - V_{be8} - R_c I_+ - \right.$$

$$\left. (V_{cc} - (R_1/2R_3) . (\beta_3/(\beta_3 + 1)) . V_r - V_{be4} + K_1 V_e * - R_i I_-) \right]$$

$$= G \left[ ((R_1/2R_3) . (\beta_3/(\beta_3 + 1)) - (R_7/R_6) . (\beta_6/(\beta_6 + 1))) V_r - K_1 V_e * \right.$$

$$\left. + V_{be4} - V_{be8} + R_i I_- - R_c I_+ \right]$$

$\beta_3$ et $\beta_6$ étant bien supérieurs à l'unité, les fractions $\beta_3/(\beta_3 + 1)$ et $\beta_6/(\beta_6 + 1)$ sont sensiblement égales à l'unité. D'autre part, le transistor $T_8$ étant homothétique aux transistors $T_4$ et $T_5$, $V_{be8}$ est égal à $V_{be4}$. Enfin, les courants d'entrée de l'amplificateur de mesure $I_+$ et $I_-$ étant égaux, les résistances $R_c$ et $R_i$ étant choisies de même valeur, le terme $R_i I_- - R_c I_+$ est nul. Le signal de mesure $V_m$ vaut donc :

$$V_m = G \left[ (R_1/2R_3 - R_7/R_6) \cdot V_r - K_1 Ve* \right]$$

Le signal de mesure $V_m$ ne dépend ainsi que de la tension de référence $V_r$ et du niveau du signal d'entrée Ve*. En notant

$$K_2 = R_1/2R_3 - R_7/R_6$$

$$V_m = G (K_2 \cdot V_r - K_1 \cdot Ve*)$$

Dans un premier mode d'utilisation, le signal de mesure $V_m$ est proportionnel au niveau du signal d'entrée Ve*. Les valeurs des résistances $R_1, R_3, R_6, R_7$ sont choisies de manière à annuler le coefficient $K_2$. Le signal de compensation se réduit à un signal de correction $V_a$ qui a même valeur que la tension de décalage $V_d$ :

$$V_a = V_{cc} - (R_1/2R_3) \cdot V_r - V_{be4} - R_l l \_$$

Le circuit de mesure, dans ce mode d'utilisation trouvera une application intéressante dans la mesure ou dans la démodulation d'un signal modulé en amplitude en fixant la constante de temps de l'intégrateur 3 à une valeur adaptée.

Dans un deuxième mode d'utilisation, le signal de mesure $V_m$ est proportionnel à la différence entre un signal de comparaison V* et le niveau du signal d'entrée Ve*, ce signal de comparaison V* étant lui-même proportionnel à la tension de référence $V_r$ :

$$V* = (K_2/K_1) \cdot V_r$$

$$V_m = G \cdot K_1 \cdot (V* - Ve*)$$

Le signal de compensation s'analyse alors comme la somme du signal de correction $V_a$ précédemment défini et d'un signal d'évaluation $V_b$ :

$$V_b = V_r \cdot (R_1/2R_3 - R_7/R_6)$$

$$V_c = V_a + V_b$$

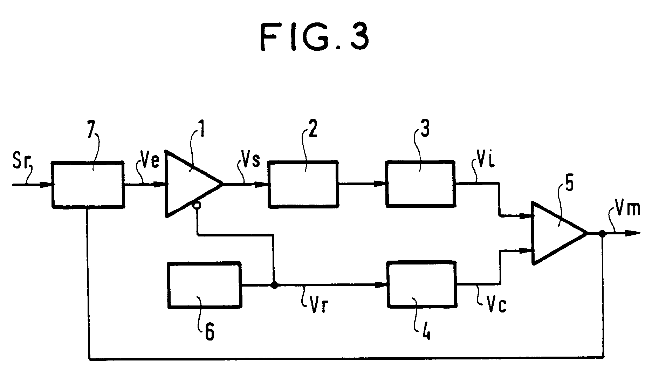

Le circuit de mesure, dans ce mode d'utilisation, trouvera une application avantageuse dans les amplificateurs à commande automatique de gain. Dans une application de ce type dont un schéma est présenté à la figure 3, un amplificateur à commande automatique de gain 7 d'un type connu amplifie un signal de réception $S_R$ pour produire le signal d'entrée Ve de l'amplificateur d'entrée 1, et reçoit comme signal de commande, le signal de mesure $V_m$ issu de l'amplificateur de mesure 5. Le circuit agit sur la gain de l'amplificateur de manière à ce que Ve* tende vers V*.

Sans sortir du cadre de l'invention, le module qui a été conventionnellement dénommé amplificateur d'entrée 1 peut constituer l'étage de sortie de l'amplificateur à commande automatique de gain 7. La composante alternative du signal de sortie $V_S$ est asservie de la même manière sur le signal de comparaison V* puisque elle est égale à $K_1$ Ve.

Les éléments $R_{10}, D_1$ d'une part, et $R_{20}, D_2$ d'autre part ont une fonction équivalente. Ils ont été schématisés de cette manière pour simplifier la présentation du circuit de mesure. Dans le cadre d'une réalisation pratique, ils seront remplacés par une seule diode D et une seule résistance $R_D$ connectée entre la tension d'alimentation $V_{cc}$ et cette diode, la deuxième électrode de cette diode recevant la tension de référence $V_r$ issue du générateur 6. Les bases des transistors $T_3$ et $T_6$ sont alors raccordées au point commun de la diode D et de la résistance $R_D$, la diode D et les transistors $T_3$ et $T_6$ étant homothétiques.

Tous les éléments formant le circuit de mesure à l'exception éventuellement du condensateur $C_i$ de l'intégrateur 3, peuvent être intégrés dans un seul circuit monolithique. Dans ce cas, ces éléments seront à la même température ou à une température très voisine, les variations relatives entre résistances seront très faibles et les éléments non linéaires tels que diodes et transistors seront homothétiques de manière pratiquement parfaites, les variations relatives de leurs dimensions géométriques étant elles aussi très faibles.

En ce qui concerne le condensateur $C_i$ c'est la valeur de sa capacité compte-tenu des contraintes technologiques, qui permettra ou interdira son intégration.

Il a été précisé que le transistor $T_6$ était homothétique du transistor $T_3$. Le rapport d'homothétie peut prendre toute valeur y compris l'unité mais dans le cas où le courant d'émetteur du transistor $T_3$ est important on peut choisir ce rapport égal à 10, par exemple, de manière à réduire la surface du circuit de mésure ainsi que sa consommation en énergie électrique. $R_6$ aura donc une valeur dix fois plus grande que $R_3$ et la surface d'émetteur du transistor $T_6$ sera dix fois plus petite que celle du transistor $T_3$.

Le circuit de mesure, dans la description qui précède, est alimenté entre une tension positive $V_{cc}$ et la masse. L'invention se généralise facilement dans le cas d'une source d'alimentation différente, notamment dans le cas d'une alimentation symétrique.

De même, le fait que l'amplificateur d'entrée 1 soit présenté comme un amplificateur différentiel dans la description d'un exemple de réalisation ne doit pas être considéré comme une limitation de l'invention.

## Revendications

1. Circuit de mesure du niveau d'un signal électrique d'entrée (Ve) comprenant un amplificateur d'entrée (1) polarisé à partir d'une tension de polarisation recevant ce signal d'entrée (Ve) et produisant un signal de sortie (Vs), suivi d'un module de détection (2) lui-même suivi d'un intégrateur (3) délivrant un signal d'intégration (Vi), ces trois éléments constituant une chaîne de mesure, ledit signal d'intégration (Vi) étant la somme d'un signal de niveau proportionnel au niveau dudit signal d'entrée (Ve) et d'un signal de décalage, ledit circuit de mesure comprenant de plus un générateur (6) produisant une tension de référence (Vr), un module de compensation (4) recevant cette tension de référence (Vr) et produisant un signal de compensation (Vc), un amplificateur de mesure différentiel (5) recevant lesdits signaux d'intégration et de compensation et produisant un signal de mesure (Vm), caractérisé en ce que, ladite tension de polarisation est ladite tension de référence (Vr) et en ce que ledit module de compensation (4) comprend des étages correspondant auxdits éléments de ladite chaîne de mesure pour acheminer ladite tension de référence (Vr) dans des conditions homothétiques de celles de ladite chaîne de mesure pour produire notamment un signal de correction ayant même valeur que ledit signal de décalage, ce signal de correction étant inclus dans ledit signal de compensation (Vc).

2. Circuit de mesure du niveau d'un signal électrique selon la revendication 1, caractérisé en ce que ledit module de compensation (4) produit un signal de compensation (Vc) comprenant, outre ledit signal de correction, un signal d'évaluation proportionnel à ladite tension de référence (Vr) générant au travers dudit amplificateur de mesure un signal de comparaison également proportionnel à ladite tension de référence (Vr), ledit signal de mesure (Vm) étant proportionnel à la différence entre ledit signal de comparaison et le niveau dudit signal d'entrée (Ve).

3. Circuit de mesure du niveau d'un signal électrique selon l'une quelconque des revendications 1 et 2, caractérisé en ce que ledit signal d'entrée (Ve) est un signal différentiel, ledit amplificateur d'entrée (1) comprend un premier transistor (T1) et un deuxième transistor (T2) identiques recevant chacun sur leurs bases une voie dudit signal d'entrée, le collecteur du premier transistor (T1) étant raccordé à une tension d'alimentation (Vcc) par l'intermédiaire d'une première résistance (R1), le collecteur du deuxième transistor (T2) étant raccordé à ladite tension d'alimentation par l'intermédiaire d'une deuxième résistance (R2) ayant même valeur que ladite première résistance (R1), les émetteurs desdits transistors (T1, T2) étant reliés au collecteur d'un troisième transistor (T3) dont l'émetteur est relié à la masse par une troisième résistance (R3) et dont la base reçoit ladite tension de référence (Vr) par l'intermédiaire d'une première diode (D1) homothétique de la jonction base-émetteur dudit troisième transistor (T3), cette diode (D1) étant polarisée par une première résistance de diode (R10) reliée à ladite tension d'alimentation (Vcc).

4. Circuit de mesure du niveau d'un signal électrique selon la revendication 3, caractérisé en ce que ledit module de détection (2) comprend un quatrième transistor (T4) dont la base est raccordée au collecteur dudit deuxième transistor (T2) et dont le collecteur est relié à ladite tension d'alimentation (Vcc), un cinquième transistor (T5) dont la base est raccordée au collecteur dudit premier transistor (T1) et dont le collecteur est relié à ladite tension d'alimentation, les émetteurs desdits quatrième (T4) et cinquième (T5) transistors ayant un point commun qui est relié à la masse par une résistance commune (R45).

5. Circuit de mesure du niveau d'un signal électrique selon la revendication 4, caractérisé en ce que ledit intégrateur (3) est formé d'une cellule R-C, la résistance d'intégration (Ri) de cette cellule reliant ledit point commun à la première entrée dudit amplificateur de mesure (5) et le condensateur d'intégration (Ci) de cette cellule étant relié d'une part à ladite première entrée et d'autre part soit à la masse, soit à la sortie dudit amplificateur de mesure (5).

6. Circuit de mesure du niveau d'un signal électrique selon l'une quelconque des revendications 4 et 5, caractérisé en ce que ledit module de compensation (4) comprend un premier étage correspondant audit amplificateur d'entrée (1) constitué d'un sixième transistor (T6) homothétique dudit troisième transistor (T3), dont l'émetteur est relié à la masse par une sixième résistance (R6), dont le collecteur est relié à ladite tension d'alimentation (Vcc) par une septième résistance (R7) et dont la base reçoit ladite tension de réfé-

rence ($V_r$) par l'intermédiaire d'une deuxième diode ($D_2$) homothétique de ladite première diode ($D_1$) et de la jonction base-émetteur de ce sixième transistor ($T_6$), cette deuxième diode ($D_2$) étant polarisée par une deuxième résistance de diode ($R_{20}$) reliée à ladite tension d'alimentation ($V_{cc}$), et en ce qu'il comprend un deuxième étage correspondant audit module de détection (2) constitué d'un septième transistor ($T_8$) homothétique dudit quatrième transistor ($T_4$), monté en collecteur commun, dont la base est reliée au collecteur dudit sixième transistor ($T_6$) et dont l'émetteur est relié d'une part à la masse par une résistance ($R_8$) et d'autre part à la deuxième entrée de l'amplificateur de mesure (5) par une résistance de compensation ($R_c$).

7. Circuit de mesure du niveau d'un signal électrique selon la revendication 6, caractérisé en ce que l'ensemble desdites première ($D_1$) et deuxième ($D_2$) diodes est formé par une seule diode homothétique aux jonctions base-émetteur desdits troisième et sixième transistors ($T_3$, $T_6$) et l'ensemble desdites résistances de diode ($R_{10}$, $R_{20}$) est formé par une seule résistance.

8. Circuit de mesure du niveau d'un signal électrique selon l'une quelconque des revendications précédentes, caractérisé en ce que tous les éléments de ladite chaîne de mesure et dudit module de compensation sont intégrés dans un circuit monolithique.

9. Circuit de mesure du niveau d'un signal électrique selon la revendication 5, caractérisé en ce que, à l'exception dudit condensateur d'intégration ($C_I$), tous les éléments de ladite chaîne de mesure et dudit module de compensation sont intégrés dans un circuit monolithique.

10. Circuit de mesure du niveau d'un signal électrique selon l'une des revendications 8 et 9, caractérisé en ce que ledit générateur (6) est également intégré dans ledit circuit monolithique.

11. Circuit de mesure du niveau d'un signal électrique selon l'une quelconque des revendications 8 à 10, caractérisé en ce que ledit amplificateur de mesure (5) est également intégré dans ledit circuit monolithique.

12. Circuit de mesure du niveau d'un signal électrique selon l'une quelconque des revendications précédentes, caractérisé en ce que ledit générateur (6) est un module dont la tension de sortie est référencée à la bande d'énergie interdite, "band-gap", d'un semi-conducteur.

13. Application du circuit de mesure du niveau d'un signal électrique selon l'une quelconque des revendications précédentes à un circuit à commande automatique de gain, ce circuit comprenant un amplificateur à commande automatique de gain (7) produisant ledit signal d'entrée (Ve) à partir d'un signal de réception ($S_r$), caractérisée en ce que le signal de commande dudit amplificateur à commande automatique de gain est ledit signal de mesure ($V_m$).

14. Application du circuit de mesure du niveau d'un signal électrique selon la revendication précédente caractérisée en ce que ledit amplificateur d'entrée (1) est l'étage de sortie dudit amplificateur à commande automatique de gain (7).

15. Application du circuit de mesure du niveau d'un signal électrique selon l'une quelconque des revendications 1 et 3 à 12 à la démodulation d'un signal modulé en amplitude, caractérisée en ce que ledit signal de correction constitue ledit signal de compensation ($V_c$).

**Patentansprüche**

1. Schaltung zum Messen des Pegels eines elektrischen Eingangssignals (Ve), mit einem das Eingangssignal ($V_e$) empfangenden Eingangsverstärker (1), der mit einer Vorspannung vorgespannt ist und ein Ausgangssignal in ($V_s$) erzeugt, gefolgt von einem Detektormodul (2), auf den seinerseits ein Integrierglied (3) folgt, das ein Integrationssignal ($V_I$) liefert, wobei diese drei Elemente eine Meßkette bilden und das Integrationssignal ($V_I$) der Summe eines dem Pegel des Eingangssignals (Ve) proportionalen Pegelsignals und eines Verschiebungssignals gleicht, wobei die Meßschaltung weiter einen Generator (6), der eine Bezugsspannung ($V_r$) erzeugt, einen Kompensationsmodul (4), der die Bezugsspannung ($V_r$) empfängt und ein Kompensationssignal ($V_c$) erzeugt, und einen Differentialmeßverstärker (5) aufweist, der das Integrations- und das Kompensationssignal empfängt und eine Meßsignal ($V_m$) erzeugt, dadurch gekennzeichnet, daß die Vorspannung die Bezugsspannung ($V_r$) ist und daß der Kompensationsmodul (4) Stufen aufweist, die den Elementen der Meßkette entsprechen, um die Bezugsspannung ($V_r$) unter den der Meßkette homothetisch entsprechenden Bedingungen so zu verarbeiten, daß insbesondere ein Korrektursignal mit dem gleichen Wert wie dem des Verschiebungssignals erzeugt wird, wobei dieses Korrektursignal im Kompensationssignal ($V_c$) enthalten ist.

2. Schaltung zum Messen des Pegels eines elektrischen Signals, nach Anspruch 1, dadurch gekennzeichnet, daß der Kompensationsmodul (4) ein Kompensationssignal ($V_c$) erzeugt, das außer dem Korrektursignal ein Bewertungssignal enthält, das dem Bezugssignal ($V_r$) proportional ist und durch den Meßverstärker ein Vergleichssignal erzeugt, das ebenfalls der Bezugsspannung ($V_r$) proportional ist, wobei das Meßsignal ($V_m$) der Differenz zwischen dem Vergleichssignal und dem Pegel des Eingangssignals (Ve) proportional ist.

3. Schaltung zum Messen des Pegels eines elektrischen Signals nach Anspruch 1 oder 2, dadurch gekennzeichnet, daß das Eingangssignal (Ve) ein Differenzsignal ist, wobei der Eingangsverstärker (1) einen ersten Transistor ($T_1$) und einen dazu identischen zweiten Transistor ($T_2$) enthält, die je an ihrer Basis einen Kanal des Eingangssignals empfangen, wobei der Kollektor des ersten Transistors ($T_1$) über einen ersten Widerstand ($R_1$) an eine Speisespannung ($V_{cc}$) angeschlossen ist und der Kollektor des zweiten Transistors ($T_2$) über einen zweiten Widerstand ($R_2$) mit dem gleichen Wert wie dem des ersten Widerstandes ($R_1$) an die Speisespannung angeschlossen ist, während die Emitter dieser Transistoren ($T_1$, $T_2$) an den Kollektor eines dritten Transistors ($T_3$) angeschlossen sind, dessen Emitter über einen dritten Widerstand ($R_3$) an Masse liegt und dessen Basis die Bezugsspannung ($V_r$) über eine erste Diode ($D_1$) empfängt, die homothetisch dem Basis-Emitter-Übergang des dritten Transistors ($T_3$) entspricht, wobei diese Diode ($D_1$) über einen ersten Diodenwiderstand ($R_{10}$) vorgespannt wird, der an die Speisespannung ($V_{cc}$) angeschlossen ist.

4. Schaltung zum Messen des Pegels eines elektrischen Signals, nach Anspruch 3, dadurch gekennzeichnet, daß der Detektormodul (2) einen vierten Transistor ($T_4$), dessen Basis an den Kollektor des zweiten Transistors ($T_2$) und dessen Kollektor an die Speisespannung ($V_{cc}$) angeschlossen ist, und einen fünften Transistor ($T_5$) aufweist, dessen Basis an den Kollektor des ersten Transistors ($T_1$) und dessen Kollektor an die Speisespannung angeschlossen ist, wobei die Emitter des vierten ($T_4$) und fünften ($T_5$) Transistors einen gemeinsamen Verbindungspunkt aufweisen, der über einen gemeinsamen Widerstand ($R_{45}$) an Masse angeschlossen ist.

5. Schaltung zum Messen des Pegels eines elektrischen Signals nach Anspruch 4, dadurch gekennzeichnet, daß das Integrierglied (3) aus einer RC-Zelle besteht, wobei der Integrationswiderstand ($R_i$) dieser Zelle den gemeinsamen Verbindungspunkt mit dem ersten Eingang des Meßverstärkers (5) verbindet und wobei der Integrationskondensator ($C_i$) dieser Zelle einerseits an den ersten Eingang und andererseits entweder an Masse oder an den Ausgang des Meßverstärkers (5) angeschlossen ist.

6. Schaltung zum Messen des Pegels eines elektrischen Signals nach Anspruch 4 oder 5, dadurch gekennzeichnet, daß der Kompensationsmodul (4) eine erste Stufe aufweist, die dem Eingangsverstärker (1) entspricht und aus einem sechsten Transistor ($T_6$) besteht, der homothetisch dem dritten Transistor ($T_3$) entspricht und dessen Emitter über einen sechsten Widerstand ($R_6$) an Masse liegt, dessen Kollektor über einen siebten Widerstand ($R_7$) an die Speisespannung ($V_{cc}$) angeschlossen ist und dessen Basis über eine zweite Diode ($D_2$), die homothetisch der ersten Diode ($D_1$) und dem Basis-Emitter-Übergang des sechsten Transistors ($T_6$) entspricht, die Bezugsspannung ($V_r$) empfängt, wobei diese zweite Diode ($D_2$) durch einen zweiten Diodenwiderstand ($R_{20}$) vorgespannt wird, der an die Speisespannung ($V_{cc}$) angeschlossen ist, daß die Meßschaltung weiter eine zweite Stufe entsprechend dem Detektormodul (2) aufweist, die aus einem siebten Transistor ($T_8$) besteht, der homothetisch dem vierten Transistor ($T_4$) entspricht und in Kollektorbasisschaltung geschaltet ist, dessen Basis an den Kollektor des sechsten Transistors ($T_6$) und dessen Emitter einerseits durch einen Widerstand ($R_8$) an Masse und andererseits über einen Kompensationswiderstand ($R_c$) an den zweiten Eingang des Meßverstärkers (5) angeschlossen ist.

7. Schaltung zum Messen des Pegels eines elektrischen Signals nach Anspruch 6, dadurch gekennzeichnet, daß die aus der ersten ($D_1$) und der zweiten Diode ($D_2$) bestehende Einheit von einer einzigen Diode gebildet wird, die homothetisch den Basis-Emitter-Übergängen des dritten und sechsten Transistors ($T_3$, $T_6$) entspricht, während die Diodenwiderstände ($R_{10}$, $R_{20}$) gemeinsam von einem einzigen Widerstand gebildet werden.

EP 0 452 557 B1

8. Schaltung zum Messen des Pegels eines elektrischen Signals nach einem beliebigen der vorherigen Ansprüche, dadurch gekennzeichnet, daß alle Elemente der Meßkette und des Kompensationsmoduls in einer monolithischen Schaltung integriert sind.

9. Schaltung zum Messen des Pegels eines elektrischen Signals nach Anspruch 5, dadurch gekennzeichnet, daß mit Ausnahme des Integrationskondensators ($C_I$) alle Elemente der Meßkette und des Kompensationsmoduls in einer monolithischen Schaltung integriert sind.

10. Schaltung zum Messen des Pegels eines elektrischen Signals nach Anspruch 8 oder 9, dadurch gekennzeichnet, daß der Generator (6) ebenfalls in die monolithische Schaltung integriert ist.

11. Schaltung zum Messen des Pegels eines elektrischen Signals, nach einem beliebigen der Ansprüche 8 bis 10, dadurch gekennzeichnet, daß der Meßverstärker (5) ebenfalls in die monolithische Schaltung integriert ist.

12. Schaltung zum Messen des Pegels eines elektrischen Signals, nach einem beliebigen der vorhergehenden Ansprüche, dadurch gekennzeichnet, daß der Generator (6) ein Modul ist, dessen Ausgangsspannung auf das verbotene Energieband, "Band-gap", eines Halbleiters bezogen ist.

13. Verwendung der Schaltung zur Messung des Pegels eines elektrischen Signals nach einem beliebigen der vorhergehenden Ansprüche in einer Schaltung mit automatischer Verstärkungsregelung, wobei die Schaltung einen Verstärker (7) mit automatischer Verstärkungsregelung aufweist, der das Eingangssignal (Ve) aus einem Empfangssignal ($S_r$) erzeugt, dadurch gekennzeichnet, daß das Steuersignal des Verstärkers mit automatischer Verstärkungsregelung das Meßsignal ($V_m$) ist.

14. Verwendung der Schaltung zum Messen des Pegels eines elektrischen Signals nach einem der vorhergehenden Ansprüche, dadurch gekennzeichnet, daß der Eingangsverstärker (1) die Ausgangsstufe des Verstärkers (7) mit automatischer Verstärkungsregelung ist.

15. Anwendung der Schaltung zum Messen des Pegels eines elektrischen Signals nach einem beliebigen der Ansprüche 1 und 3 bis 12 auf die Demodulation eines amplitudenmodulierten Signals, dadurch gekennzeichnet, daß das Korrektursignal das Kompensationssignal ($V_c$) ist.

**Claims**

1. A measurement circuit for measuring the level of an input electrical signal (Ve), the circuit comprising an input amplifier (1) biased from a bias voltage, receiving said input signal (Ve), and producing an output signal (Vs), followed by a detector module (2) itself followed by an integrator (3) delivering an integration signal (Vi), these three components constituting a measurement channel, said integration signal (Vi) being the sum of an offset signal and of a level signal which is proportional to the level of said input signal (Ve), said measurement circuit further including a generator (6) producing a reference voltage (Vr), a compensation module (4) receiving said reference voltage (Vr) and producing a compensation signal (Vc), and a differential measurement amplifier (5) receiving said integration signal and said compensation signal and producing a measurement signal (Vm), the measurement circuit being characterized in that said bias voltage is constituted by said reference voltage (Vr), and in that said compensation module (4) comprises stages corresponding to said components of said measurement channel for conveying said reference voltage (Vr) through conditions that match the conditions of said measurement channel, thereby producing, in particular, a correction signal having the same value as said offset signal, said correction signal being included in said compensation signal (Vc).

2. A measurement circuit for measuring the level of an electrical signal according to claim 1, characterized in that said compensation module (4) produces a compensation signal (Vc) comprising, in addition to said correction signal, an evaluation signal which is proportional to said reference voltage (Vr) generating a comparison signal through said measurement amplifier, which comparison signal is also proportional to said reference voltage (Vr), said measurement signal (Vm) being proportional to the difference between said comparison signal and the level of said input signal (Ve).

3. A measurement circuit for measuring the level of an electrical signal according to claim 1 or 2, characterized in that said input signal (Ve) is a differential signal, said input amplifier (1) comprising identical first and second transistors (T1, T2) each receiving a respective one of the input signal paths on its base, the collector of the first transistor (T1) being connected to a power supply voltage (Vcc) via a first resistor (R1), the collector of the second transistor (T2) being connected to said power supply voltage via a second resistor (R2) having the same resistance as said first resistor (R1), the emitters of said transistors (T1, T2) being connected to the collector of a third transistor (T3) whose emitter is connected to ground via a third resistor (R3) and whose base receives said reference voltage (Vr) via a first diode (D1) which matches the base-emitter junction of said third transistor (T3), said diode (D1) being biased by a first diode resistor (R10) connected to said power supply voltage (Vcc).

4. A measurement circuit for measuring the level of an electrical signal according to claim 3, characterized in that said detector module (2) comprises a fourth transistor (T4) whose base is connected to the collector of said second transistor (T2) and whose collector is connected to said power supply voltage (Vcc), and a fifth transistor (T5) whose base is connected to the collector of said first transistor (Vcc) and whose collector is connected to said power supply voltage, the emitters of said fourth and fifth transistors (T4, T5) having a common point which is connected to ground via a common resistor (R45).

5. A measurement circuit for measuring the level of an electrical signal according to claim 4, characterized in that said integrator (3) is constituted by an R-C cell, the integration resistor (Ri) of said cell connecting said common point to the first input of said measurement amplifier (5) and the integration capacitor (Ci) of said cell being connected firstly to said first input and secondly either to ground or to the output of said measurement amplifier (5).

6. A measurement circuit for measuring the level of an electrical signal according to claim 4 or 5, characterized in that said compensation module (4) comprises a first stage corresponding to said input amplifier (1) and constituted by a sixth transistor (T6) matching said third transistor (T3) with the emitter of the sixth transistor being connected to ground by a sixth resistor (R6), with its collector connected to said power supply voltage (Vcc) via a seventh resistor (R7), and with its base receiving said reference voltage (Vr) via a second diode (D2) matching said first diode (D1) and the base-emitter junction of said sixth transistor (T6), said second diode (D2) being biased by a second diode resistor (R20) connected to said power supply voltage (Vcc), and in that it comprises a second stage corresponding to said detector module (2) and constituted by a seventh transistor (T8) matching said fourth transistor (T4) and connected in common collector mode, with the base of the seventh transistor being connected to the collector of said sixth transistor (T6), and with its emitter being connected firstly to ground via a resistor (R8) and secondly to the second input of the measurement amplifier (5) via a compensation resistor (Rc).

7. A measurement circuit for measuring the level of an electrical signal according to claim 6, characterized in that said first and second diodes (D1, D2) are constituted by a single diode which matches the base-emitter junctions of both of said third and the sixth transistors (T3, T6), and said diode resistors (R10, R20) are constituted by a single resistor.

8. A measurement circuit for measuring the level of an electrical signal according to any preceding claim, characterized in that all of the components of said measurement channel and of said compensation module are integrated in a monolithic circuit.

9. A measurement circuit for measuring the level of an electrical signal according to claim 5, characterized in that all of the components of said compensation module and of said measurement channel other than said integration capacitor (Ci) are integrated in a monolithic circuit.

10. A measurement circuit for measuring the level of an electrical signal according to claim 8 or 9, characterized in that said generator (6) is also integrated in said monolithic circuit.

11. A measurement circuit for measuring the level of an electrical signal according to any one of claims 8 to 10, characterized in that said measurement amplifier (5) is also integrated in said monolithic circuit.

12. A measurement circuit for measuring the level of an electrical signal according to any preceding claim, characterized in that said generator (6) is a module whose output voltage is referenced to the band gap of a semiconductor.

13. An application of the measurement circuit for measuring the level of an electrical signal according to any preceding claim to an automatic gain control circuit, said circuit comprising an AGC amplifier (7) producing said input signal (Ve) from a reference signal (Sr), characterized in that the control signal of said AGC amplifier is said measurement signal (Vm).

14. An application of the measurement circuit for measuring the level of an electrical signal according to the preceding claim, characterized in that said input amplifier (1) is the output stage of said AGC amplifier (7).

15. An application of the measurement circuit for measuring the level of an electrical signal according to any one of claims 1, and 3 to 12 to demodulating an amplitude modulated signal, characterized in that said correction signal constitutes said compensation signal (Vc).

# FIG.1

# FIG.2

# FIG. 3